# FASCICULE DE BREVET EUROPEEN

(11) **EP 0 506 578 B1**
(45) Date de publication et mention de la délivrance du brevet: **05.06.1996**
(21) Numéro de dépôt: 92400867.5
(22) Date de dépôt: 27.03.1992
(51) Int. Cl.: G01R 31/26, G01R 27/26

(54) **Procédé et dispositif de qualification d'un système capacitif**
Verfahren und Gerät zur Beurteilung eines kapazitiven Systems
Method and device for qualifying a capacitive system

(30) Priorité: 29.03.1991 FR 9103872
(43) Date de publication de la demande: 30.09.1992
(73) Titulaire: COMMISSARIAT A L'ENERGIE ATOMIQUE, F-75015 Paris (FR)
(72) Inventeur: Toffoli, Alain, F-38450 Vif (FR); Pelloie, Jean-Luc, F-38430 Moirans (FR)
(74) Mandataire: Ilgart, Jean-Christophe

(56) Documents cités:
- FR-A- 2 514 903
- IEEE TRANSACTIONS ON ELECTRON DEVICES. vol. ED-22, no. 11, Novembre 1975, NEW YORK US pages 1051 - 1052; R.F. PIERRET ET AL.: 'A MODIFIED LINEAR SWEEP TECHNIQUE FOR MOS-C GENERATION RATE MEASUREMENTS'
- IEEE TRANSACTIONS ON INSTRUMENTATION AND MEASUREMENT. vol. 37, no. 1, Mars 1988, NEW YORK US pages 86 - 89; H.S. WOON ET AL.: 'A COMPUTER CONTROLLED SYSTEM FOR TRANSIENT CAPACITANCE MEASUREMENTS OF DEEP LEVELS IN SEMICONDUCTORS'

## Description

La présente invention a pour objet un procédé et un dispositif de qualification d'un système capacitif : simple composant, circuit électrique, circuit électronique semi-conducteur ou non. Elle s'applique notamment à des mesures de "durée de vie" ou bien à des mesures de qualification spectroscopique dans le cadre d'un système capacitif semi-conducteur.

Un procédé et un dispositif pour la qualification d'un système capacitif sont décrits dans un article rédigé par R.F. Pierret et W. Small, paru dans la revue IEEE Transactions on electron Devices,en Novembre 1975, vol. 3, pp.1051-1052. Ce document décrit les caractéristiques du préambule de la revendication 1. On applique au système à tester une première tension de polarisation V1 de manière à mettre le système capacitif en régime d'accumulation. Puis on applique une seconde tension de polarisation V2 de manière à mettre le système capacitif en régime de désertion (ou déplétion). Le changement de tension de polarisation provoque une variation de la valeur capacitive du système testé ; celle-ci passe de C1 à C2.

Si la tension de polarisation, après son passage de V1 à V2 est maintenue constante, la capacité évolue progressivement vers une valeur d'équilibre C3.

Conformément au procédé décrit dans cet article, on asservit la tension de polarisation de manière à maintenir la valeur de la capacité constante à la valeur C2. La mesure de la variation de la tension de polarisation permet de caractériser le système capacitif en déduisant la "durée de vie", par exemple.

Un capacimètre permet la mesure de la capacité du système capacitif. Préalablement au test de qualification, un opérateur mesure la valeur C2 de la capacité en régime de déplétion qui va servir ensuite de consigne pour l'asservissement.

Pour effectuer le test, la valeur de consigne est réglée manuellement. La mesure effectuée par le capacimètre au cours du temps est comparée à la valeur de consigne pour régler l'asservissement de la tension de polarisation.

Ce procédé est peu précis sur le début du cycle de mesure; il ne permet pas d'effectuer des tests dans le cas où la variation de la tension d'asservissement en fonction du temps est rapide (supérieure ou égale à 5 V/s).

En effet, dans ce cas, le système capacitif demeure très peu en régime de désertion (pendant une durée très inférieure à une seconde). La valeur de la capacité servant de consigne est relevée visuellement après un premier passage de la capacité en régime de désertion, d'où l'imprécision.

L'invention remédie à cet inconvénient: la mesure de la valeur de la capacité en régime de déplétion, qui sert de valeur de consigne, est effectuée automatiquement pendant le cycle de test. Cela permet une mesure de la valeur C2 d'autant plus précise qu'elle est rapide, ce qui autorise la réalisation des tests de qualification même en cas de variation rapide.

Le document d'IEEE transactions on instrumentation measurement de Woon, Tan et Ng intitulé « A computer controled system for transient capacitance measurement of deep levels in semiconductors » (vol.37, 1988, mars, n°1, New York, p.86 à 89), qui décrit les caractéristiques du préambule de la revendication 5, décrit une méthode de qualification d'un système capacitif en mesurant sa réponse transitoire de décharge à la suite d'une impulsion de tension, grâce à un circuit d'échantillonnage efficace comprenant notamment un ordinateur.

L'invention concerne donc un procédé de qualification d'un système capacitif selon la revendication 1.

Le facteur de proportionalité de la tension d'asservissement est liée aux moyens électroniques utilisés pour mettre en oeuvre le procédé. Le régime initial peut être un régime d'accumulation ou un régime d'inversion par exemple dans le cadre d'un dispositif semi-conducteur MIS.

Selon une variante du procédé, l'enregistrement de la tension de consigne est effectué après une détection d'une variation brutale de la valeur capacitive allant des valeurs C1 à C2.

Selon une autre variante du procédé, l'enregistrement de la tension de consigne est effectué à partir d'un instant prédéterminé compté à partir du début de la seconde période

Que ce soit dans l'une ou l'autre des variantes précédentes, la temporisation introduite permet d'enregistrer une tension correspondant à une valeur stabilisée de la capacité en régime de désertion et de ne pas tenir compte des comportements intermédiaires.

De manière avantageuse, l'enregistrement de la tension de consigne consiste en un échantillonnage pendant une durée déterminée de la tension correspondant à la valeur capacitive et en une mémorisation sous forme numérique de la tension échantillonnée.

L'enregistrement de la tension de consigne sous forme numérique permet de minimiser les fluctuations apparaissant éventuellement sur la valeur de cette tension et de conserver une valeur fiable tout au long du test.

La présente invention concerne aussi un dispositif automatique de qualification d'un système capacitif selon la revendication 5.

On entend par mesure de tension correspondant à une valeur capacitive non pas une lecture de cette valeur mais l'envoi de cette tension aux moyens de mesure de tension, aux moyens d'enregistrement et au générateur de tension.

Selon une variante du procédé et du dispositif de l'invention, pour d'assurer que la capacité du système à qualifier demeure bien en régime de désertion pendant la troisième période, on saisit la tension correspondant à cette valeur capacitive par les moyens de commande via les moyens de mesure de tension et le capacimètre.

De manière avantageuse, les moyens d'enregistrement comprennent :
des moyens d'échantillonnage commandables connectés en sortie du capacimètre et aptes à effectuer un échantillonnage de la tension correspondant à une valeur capacitive délivrée en sortie du capacimètre, un convertisseur analogique/numérique commandable relié en entrée à une sortie des moyens d'échantillonnage,
des moyens de mémorisation commandables connectés en entrée à une sortie du convertisseur analogique/numérique,
un convertisseur numérique/analogique connecté par une entrée à une sortie des moyens de mémorisation.

Le convertisseur numérique/analogique peut être commandable ou non suivant les moyens utilisés pour réaliser ce convertisseur. On entend par ailleurs par moyens commandables, des moyens commandés par les moyens de commande et donc reliés à ces derniers.

Selon une variante de réalisation, les moyens d'enregistrement comprennent des moyens de déclenchement connectés en sortie du capacimètre et aptes à détecter une variation brutale de la valeur capacitive mesurée par le capacimètre, à délivrer à la suite de cette détection un signal de déclenchement sur une sortie reliée à une entrée des moyens de commande.

Selon une variante de réalisation, les moyens de déclenchement comprennent un dérivateur.

De manière avantageuse, le générateur de tension comprend :
une source de tension commandable apte à délivrer successivement les tensions V1 et V2 sur une sortie,
un amplificateur différentiel relié par une première entrée à la sortie du capacimètre et par une seconde entrée à la sortie des moyens d'enregistrement,
un interrupteur commandable relié à une sortie de l'amplificateur différentiel,
un sommateur connecté par une première entrée à l'interrupteur et par une seconde entrée à la source de tension.

Les moyens de commande peuvent être soit intégrés avec les autres éléments du dispositif dans un ensemble, soit faire partie d'un ensemble annexe.

D'autres caractéristiques et avantages de l'invention apparaîtront mieux après la description qui suit donnée à titre explicatif et nullement limitatif. Cette description se réfère à des dessins annexés sur lesquels :
la figure 1 représente schématiquement un dispositif conforme à l'invention,
la figure 2 représente schématiquement des moyens d'enregistrement conformes à l'invention,
la figure 3 représente schématiquement un générateur de tension conforme à l'invention,
la figure 4 représente schématiquement le chronogramme des différentes tensions intervenant dans la mise en oeuvre d'un procédé conforme à l'invention.

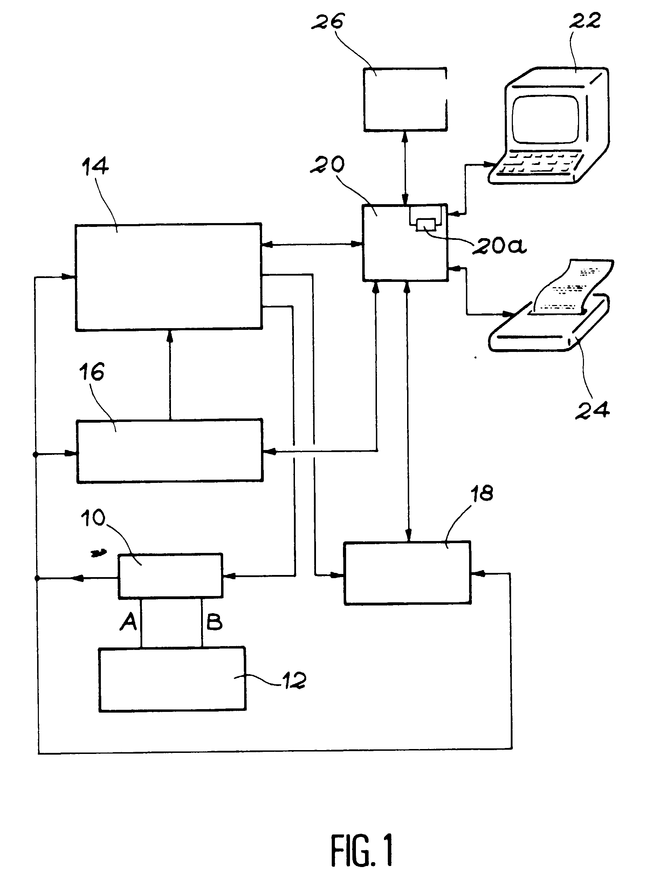

En référence à la figure 1, on décrit maintenant un dispositif conforme à l'invention. Un capacimètre 10, par exemple du type de ceux commercialisés par la Société Boonton sous la référence 72B, est connecté par des bornes A et B au système capacitif 12 à tester. Le capacimètre 10 applique une tension de polarisation réglable entre ses bornes. Il délivre sur une sortie une tension correspondant à la valeur capacitive mesurée.

Un générateur de tension 14, commandable et asservi, connecté par une entrée à la sortie du capacimètre 10 délivre sur une première sortie connectée à une entrée du capacimètre 10 la tension de polarisation qui est recopiée entre les bornes du capacimètre 10.

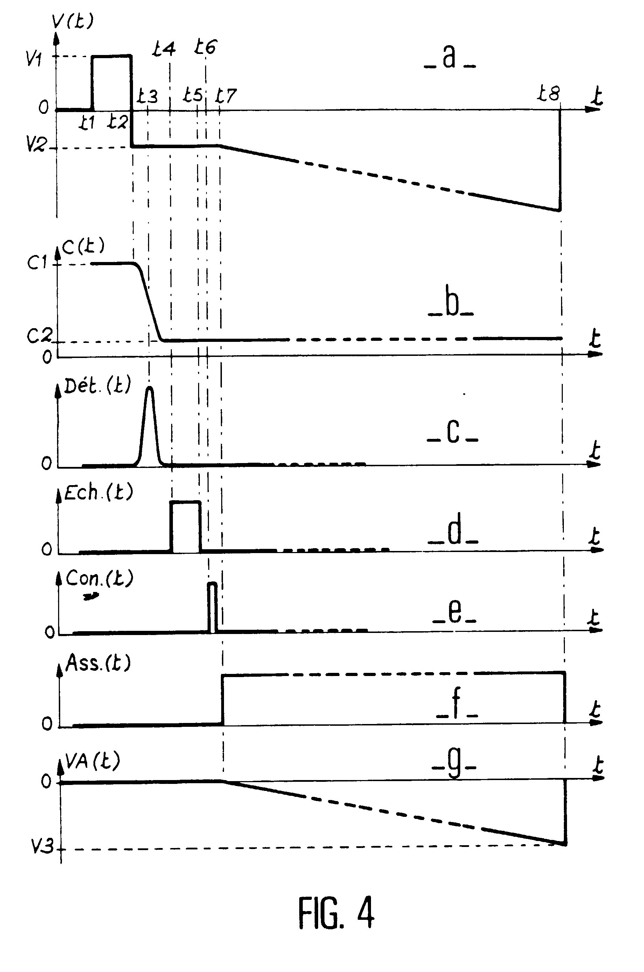

Comme on peut le voir sur la figure 4, partie a, la tension de polarisation V(t) varie au cours du temps.

Pendant une première période allant de t1 à t2, la tension de polarisation prend une valeur V1 apte à mettre le système capacitif 12 en régime initial qui peut être par exemple un régime d'accumulation représenté sur la figure 4 ou un régime d'inversion.

Pendant une seconde période allant de t2 à t7, la tension de polarisation prend une valeur V2 apte à mettre le système capacitif 12 en régime de désertion.

Pendant une troisième période allant de t7 à t8, la tension de polarisation prend une valeur qui varie au cours du temps de manière à conserver le système capacitif 12 en régime de désertion. Cette dernière tension de polarisation est constituée d'une tension d'asservissement VA(t) additionnée à V2.

Le générateur de tension 14 délivre sur une seconde sortie la tension d'asservissement seule. Les variations de cette dernière sont représentées sur la figure 4, partie g.

La figure 4, partie b, représente schématiquement les variations de la capacité du système capacitif 12 au cours des trois périodes précédentes. Entre t1 et t2, la capacité prend la valeur C1 représentative du régime initial qui peut être par exemple l'accumulation ou l'inversion dans le cas d'un système capacitif semi-conducteur MIS.

A partir de t2, instant marquant le passage de la tension de polarisation de V1 à V2, et jusqu'à un temps t4, la capacité est en régime transitoire. De t4 à t7, elle prend la valeur C2 représentative d'un état du régime de désertion.

Après t7, grâce à l'asservissement de la tension de polarisation, la capacité est maintenue constante à la valeur C2 avec une précision inférieure ou égale à 0,1 %.

Des moyens d'enregistrement commandables 16 sont reliés d'une part, par une entrée à la sortie du capacimètre 10 et d'autre part, par une sortie à une entrée du génénérateur de tension 14. Ils enregistrent à partir d'un instant prédéterminé de la seconde période la tension correspondant à la valeur capacitive pendant le régime de désertion et délivrent cette valeur à volonté sur la sortie (cette tension servant de tension de consigne, comme on le verra ultérieurement).

Des moyens de mesure de tension tels qu'un voltmétre 18 sont reliés par une première entrée à la sortie du capacimètre 10 et par une seconde entrée à la seconde sortie du générateur de tension 14. Il délivre à volonté sur une sortie la valeur de la tension d'enregistrement et celle délivrée par le capacimètre 10. Ces valeurs permettent de qualifier le système capacitif 12, par exemple en déduisant la durée de vie ou toute autre caractéristique. Des moyens de commande 20 comprenant une horloge 20a gèrent et commandent le fonctionnement du générateur de tension 14, les moyens d'asservissement 16 et le voltmètre 18. Ils peuvent être constitués par un processeur. Ce dernier peut être relié à un terminal 22 permettant un contrôle extérieur ainsi qu'à une imprimante 24.

Les moyens de commande 20 sont aussi reliés à une mémoire 26 où est enregistré le résultat des diférentes mesures.

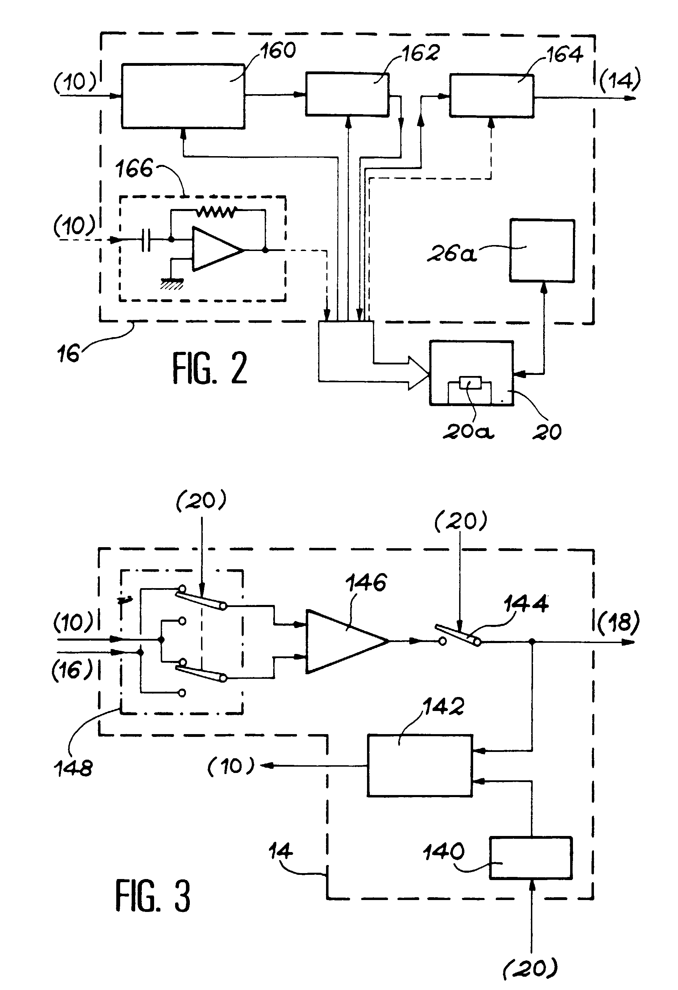

La figure 2 représente schématiquement un exemple de moyens d'enregistrement 16 conformes à l'invention. Ceux-ci comprennent un échantillonneur-bloqueur 160 échantillonnant, sous la commande du processeur 20 et pendant une durée déterminée par exemple de l'ordre de quelques ms, la tension correspondant à la valeur capacitive mesurée par le capacimètre 10.

La tension échantillonnée, analogique, est convertie en une valeur numérique par un convertisseur analogique/numérique 162 commandé par le processeur 20. La valeur numérique est enregistrée sous la commande du processeur 20 dans une mémoire 26a qui peut être un plan-mémoire de la mémoire 26 ou une mémoire annexe.

L'enregistrement en mémoire de la valeur numérique correspondant à la tension échantillonnée, garantit la fiabilité de cette valeur et permet d'éviter les dérives intervenant lors d'un enregistrement analogique.

La tension enregistrée sert de tension de consigne pour l'asservissement. Elle est délivrée (par l'intermédiaire du processeur 20) à l'entrée d'un convertisseur numérique/analogique 164. La valeur analogique est délivrée en sortie des moyens d'enregistrement sur une entrée du générateur de tension asservi 14.

Selon une première variante de réalisation, la commande de l'échantillonnage est déclenchée par un signal de déclenchement délivré par des moyens de déclenchement. Ces derniers sont réalisés par un dérivateur 166 connecté en entrée à la sortie du capacimètre 10 et en sortie au processeur 20. Ce dérivateur détecte une variation brutale de la tension correspondant à la valeur capacitive et délivre une impulsion de tension servant de signal de déclenchement.

La figure 4, partie c, représente schématiquement l'impulsion de tension Det(t) qui apparait à l'instant t3 pendant le régime transitoire (entre les instants t2 et t4) du système capacitif.

Comme on peut le voir sur la figure 4, partie d, représentant la commande d'échantillonnage Ech(t) délivrée par le processeur 20, l'échantillonnage débute à l'instant t4 après une durée prédéterminée (prenant en compte le temps de réponse du capacimètre) suivant l'instant t3 d'apparition du signal de déclenchement. Cette temporisation est telle que l'échantillonnage est effectué entre les instants t4 et t5 durant la période où le système capacitif est en régime de désertion et hors du régime transitoire, ce qui garantit la valeur de la tension servant de consigne pour l'asservissement.

Selon une autre variante de réalisation des moyens d'enregistrement, le processeur 20 commande l'échantillonnage à un instant déterminé après la commande du changement de tension de polarisation faisant passer le système capacitif du régime initial d'accumulation au régime de désertion. De même que précédemment, la temporisation permet de déclencher l'échantillonnage lorsque le régime de désertion est stabilisé.

L'échantillonnage terminé, le processeur 20 commande (signal Con(t), fig.4, partie e) les conversions analogique/numérique et numérique/analogique.

La figure 3 représente schématiquement un générateur de tension 14. Ce dernier comporte une source de tension commandable 140 connectée au processeur 20. Cette source de tension 140 est apte à délivrer successivement (sous la commande du processeur 20) la tension V1 permettant de mettre le système capacitif 12 en régime initial d'accumulation et la tension V2 permettant de mettre le système capacitif 12 en régime de désertion.

La nature du système capacitif détermine la valeur et le signe des tensions V1 et V2.

L'homme du métier connaît ou sait déterminer la valeur et le signe des tensions V1 et V2. V1 et V2 sont déterminés, par exemple pour un système capacitif semi-conducteur MIS, à partir d'une autre caractérisation appelée C(V) (variation de la capacité en fonction de la tension de polarisation qui est appliquée à ses bornes). Cette caractérisation permet de déterminer une tension V1 qui place la capacité dans un régime initial, qui peut être par exemple l'accumulation ou l'inversion, et une tension V2 qui place la capacité en régime de désertion. A titre d'exemple, pour un dispositif semi-conducteur de type N, la tension V1 correspondant au régime initial est positive si le régime est l'accumulation, et négative mais supérieure à V2 si le régime est l'inversion ; la tension V2 est négative. C'est l'inverse pour un dispositif de type P.

Le générateur de tension 14 produit aussi la tension d'asservissement VA(t) (fig.4, partie g). Cette dernière est proportionnelle à la différence, effectuée par l'amplificateur différentiel 146, entre la tension délivrée par le capacimètre 10 et la tension de consigne délivrée par les moyens d'enregistrement 16. Des moyens de commutation 148 permettent, sous la commande du processeur 20, de connecter les sorties du capacimètre 10 et des moyens d'enregistrement 16 aux entrées + et - de l'amplificateur différentiel, suivant Le signe de la polarisation V2 du système capacitif 12.

Un interrupteur 144, commandé par le processeur 20, est connecté en sortie de l'amplificateur différentiel 146. L'interrupteur 144 est par ailleurs relié à une première entrée d'un sommateur 142. Une seconde entrée du sommateur 142 est connectée à la sortie de la source de tension 140.

La figure 4, partie f, représente schématiquement le signal Ass(t) de commande de l'interrupteur 144 délivré par le processeur 20.

Jusqu'à l'instant t7, l'interrupteur 144 est ouvert et le sommateur 142 délivre sur sa sortie les tensions V1 et V2 successivement.

L'interrupteur 144 est fermé à partir de t7 et le sommateur 142 délivre sur sa sortie la tension V2 provenant de 140 additionnée à la tension d'asservissement VA provenant de 146.

La sortie du sommateur 142 est connectée à l'entrée du capacimètre 10 et lui fournit les différentes tensions de polarisation.

La tension d'asservissement est aussi délivrée sur une sortie du générateur de tension 14 connectée au voltmètre 18.

Le voltmètre délivre le résultat de ces mesures au processeur 20 pour traitement. Par exemple, la "durée de vie" d'un dispositif semi-conducteur peut être déterminée à partir de la pente de VA(t).

La mesure est arrêtée par le processeur 20 lorsque la tension d'asservissement VA(t) prend une valeur V3 déterminée ou bien à un instant t8 déterminé. La troisième période allant de t7 à t8 pendant laquelle la mesure est effectuée peut durer de quelques secondes à quelques heures alors que la seconde période allant de t2 à t7 dure de l'ordre de quelques millisecondes.

## Revendications

1. Procédé de qualification d'un système capacitif consistant à :
a)pendant une première période, appliquer une première tension V1 de polarisation au système capacitif (12) à qualifier, cette tension V1 mettant le système capacitif (12) dans un régime initial avec une valeur capacitive C1 donnée,
b)pendant une seconde période, appliquer une seconde tension V2 de polarisation au système capacitif (12) à qualifier, cette tension V2 mettant le système capacitif (12) en régime de désertion avec une valeur capacitive donnée C2, et mesurer la tension qui est délivrée par un capacimètre et qui correspond à la valeur capacitive C2 du système à qualifier,
c)pendant une troisième période, appliquer au système capacitif (12) une tension d'asservissement additionnée à la tension V2 de manière à maintenir le système capacitif (12) en régime de désertion avec la valeur C2, ladite tension d'avertissement étant proportionnelle à la différence entre une tension de consigne et la tension correspondant à la valeur capacitive mesurée pendant la troisième période,
d)mesurer la tension d'asservissement dont la variation temporelle permet la qualification désirée du système capacitif,
caractérisé en ce que :
e) ces trois périodes se succèdent,
f) dans un intervalle de temps prédéterminé durant la seconde période dans lequel le système capacitif est en régime de désertion et hors du régime transitoire, on enregistre automatiquement la tension correspondant à la valeur capacitive C2, cette tension servant dedite tension de consigne.

2. Procédé selon la revendication 1, caractérisé en ce que l'enregistrement de la tension de consigne est effectué après une détection d'une variation brutale de la valeur capacitive allant des valeurs C1 à C2.

3. Procédé selon la revendication 1, caractérisé en ce que l'enregistrement de la tension de consigne est effectué à partir d'un instant prédéterminé compté à partir du début de la seconde période.

4. Procédé selon la revendication 1, caractérisé en ce que l'enregistrement de la tension de consigne consiste en un échantillonnage pendant une durée déterminée de la tension correspondant à la valeur capacitive et en une mémorisation sous forme numérique de la tension échantillonnée.

5. Dispositif automatique de qualification d'un système capacitif, comprenant :
- un capacimètre (10) apte à délivrer une tension de polarisation entre des bornes (A, B) reliées au système capacitif (12) et sur une sortie un signal continu proportionnel à une valeur capacitive mesurée entre ses bornes,
- un générateur de tension (14) commandable et apte à délivrer successivement sur une première sortie :
pendant une première période, une tension V1 de valeur prédéterminée pour mettre le système capacitif (12) dans un régime initial,
pendant une seconde période, une tension V2 de valeur prédéterminée pour mettre le système capacitif (12) en régime de désertion,
- des moyens d'enregistrement (16) commandables reliés à la sortie du capacimètre (10) et aptes à enregistrer et délivrer une tension de consigne correspondant à une valeur capacitive mesurée pendant la seconde période,
- des moyens de mesure de tension commandables (18) connectés en entrée à la sortie du capacimètre (10) et aptes à délivrer, à volonté, une tension correspondant à une valeur capacitive mesurée au moins à partir de la seconde période,
- des moyens de commande (20) comprenant une horloge et connectés au générateur de tension, aux moyens d'enregistrement (16) et aux moyens de mesure de tension (18), lesdits moyens de commande (20) commandant le fonctionnement du générateur de tension (18), les moyens d'enregistrement (16) et les moyens de mesure de tension (18),
caractérisé en ce que :
- le générateur de tension (14) est asservi et connecté par une première entrée à la sortie du capacimètre (10),
- la première sortie du générateur de tension (14) est connectée à une entrée du capacimètre (10),
- le générateur de tension (14) est apte à délivrer sur la première sortie, pendant une troisième période succédant à la seconde, une tension d'asservissement additionnée à la tension V2, cette tension d'asservissement étant proportionnelle à la différence entre la tension de consigne et la tension correspondant à la valeur capacitive mesurée par le capacimètre pendant la troisième période,
et sur une seconde sortie, la tension d'asservissement seule,
- la tension de consigne est délivrée sur une sortie des moyens d'enregistrement (16) connectée à une seconde entrée du générateur de tension (14),
- les moyens de mesure de tension (18) sont aussi connectés à la seconde sortie du générateur de tension (14) et sont aptes à délivrer à volonté aussi la tension d'asservissement.

6. Dispositif selon la revendication 5, caractérisé en ce que les moyens d'enregistrement (16) comprennent :
des moyens d'échantillonnage (160) commandables connectés en sortie du capacimètre (10) et aptes à effectuer un échantillonnage de la tension correspondant à une valeur capacitive délivrée en sortie du capacimètre,
un convertisseur analogique/numérique (162) commandable relié en entrée à une sortie des moyens d'échantillonnage,
des moyens de mémorisation (26a) connectés en entrée à une sortie du convertisseur analogique/numérique,
un convertisseur numérique/analogique (164) connecté par une entrée à une sortie des moyens de mémorisation (26a).

7. Dispositif selon la revendication 6, caractérisé en ce que les moyens d'enregistrement (16) comprennent des moyens de déclenchement (166) connectés en sortie du capacimètre (10) et aptes à détecter une variation brutale de la valeur capacitive mesurée par le capacimètre (10), à délivrer à la suite de cette détection un signal de déclenchement sur une sortie reliée à une entrée des moyens de commande (20).

8. Dispositif selon la revendication 7, caractérisé en ce que les moyens de déclenchement (166) comprennent un dérivateur.

9. Dispositif selon la revendication 5, caractérisé en ce que le générateur de tension (14) comprend :
- une source de tension (140) commandable apte à délivrer successivement les tensions V1 et V2 sur une sortie,
- un amplificateur différentiel (146) relié par une première entrée à la sortie du capacimètre (10) et par une seconde entrée à la sortie des moyens d'enregistrement (16),
- un interrupteur (144) commandable relié à une sortie de l'amplificateur différentiel (146) et à la seconde sortie du générateur de tension (14),
- un sommateur (142) connecté par une première entrée à la seconde sortie du générateur de tension(14) et par une seconde entrée à la source de tension (140) et ayant comme sortie la première sortie du générateur de tension (14).

## Patentansprüche

1. Verfahren zur Beurteilung eines kapazitiven Systems, darin bestehend:
a) während einer ersten Periode eine erste Polarisations- bzw. Vorspannung V1 an das zu beurteilende kapazitive System (12) zu legen, wobei diese Spannung V1 das kapazitive System (12) in einen Anfangsbetriebszustand mit einem bestimmten kapazitiven Wert C1 versetzt,
b) während einer zweiten Periode eine zweite Polarisations- bzw. Vorspannung V2 an das zu beurteilende kapazitive System (12) zu legen, wobei diese Spannung V2 das kapazitive System (12) in einen Entleerungsbetriebszustand mit einem bestimmten kapazitiven Wert C2 versetzt, und die Spannung zu messen, die durch einen Kapazitätsmesser geliefert wird und die dem kapazitiven Wert C2 des zu beurteilenden Systems entspricht,
c) während einer dritten Periode an das kapazitive System (12) eine zur Spannung V2 addierte Regelspannung zu legen, um das kapazitive System (12) im Entleerungsbetriebszustand mit dem Wert C2 zu halten, wobei besagte Regelspannung proportional ist zu der Differenz zwischen einer Sollspannung und der Spannung, die dem während der dritten Periode gemessenen kapazitiven Wert entspricht,
d) die Regelspannung zu messen, deren zeitliche Veränderung die gewünschte Beurteilung des kapazitiven Systems ermöglicht,
**dadurch gekennzeichnet,** daß :
e) diese drei Perioden aufeinanderfolgen,
f) in einem festgelegten Zeitintervall während der zweiten Periode, in der das kapazitive System im Entleerungsbetriebszustand ist und aus dem Überqanqsbetriebszustand heraus ist, man automatisch die dem kapazitiven Wert C2 entsprechende Spannung aufzeichnet, wobei diese Spannung als besagte Sollspannung dient.

2. Verfahren nach Anspruch 1, dadurch gekennzeichnet, daß die Aufzeichnung der Sollspannung nach einer Feststellung einer plötzlichen Veränderung des von den Werten C1 bis C2 gehenden kapazitiven Werts erfolgt.

3. Verfahren nach Anspruch 1, dadurch gekennzeichnet, daß die Aufzeichnung der Sollspannung ab einem festgelegten Zeitpunkt erfolgt, gezählt ab dem Beginn der zweiten Periode.

4. Verfahren nach Anspruch 1, dadurch gekennzeichnet, daß die Aufzeichnung der Sollspannung aus einer Probennahme bzw. Abtastung der dem kapazitiven Wert entsprechenden Spannung während einer festgelegten Zeitdauer besteht und aus einer Speicherung der abgetasteten Spannung in digitaler Form.

5. Automatische Vorrichtung zur Beurteilung eines kapazitiven Systems, umfassend:
- einen Kapazitätsmesser (10), imstande eine Vor- bzw. Polarisationsspannung zwischen den mit dem kapazitiven System (12) verbundenen Anschlüssen (A, B) zu liefern und an einem Ausgang ein kontinuierliches Signal, proportional zu einem zwischen seinen Anschlüssen gemessenen kapazitiven Wert,
- einen Spannungsgenerator (14) steuerbar und fähig, nacheinander an einem ersten Ausgang zu liefern:
während einer ersten Periode eine Spannung V1 eines vorbestimmten Werts, um das kapazitive System (12) in einen Anfangsbetriebszustand zu versetzen, während einer zweiten Periode eine Spannung V2 eines vorbestimmten Werts, um das kapazitive System (12) in den Entleerungsbetriebszustand zu versetzen,
- steuerbare Aufzeichnungseinrichtungen (16), verbunden mit dem Ausgang des Kapazitätsmessers (10) und fähig, eine einem während der zweiten Periode gemessenen kapazitiven Wert entsprechende Sollspannung aufzuzeichnen und zu liefern,
- steuerbare Meßeinrichtungen (18), mit dem Eingang angeschlossen an den Ausgang des Kapazitätsmessers (10) und fähig, nach Bedarf eine Spannung zu liefern, die einem wenigstens ab der zweiten Periode gemessenen kapazitiven Wert entspricht,
- Steuereinrichtungen (20), einen Taktgeber umfassend und verbunden mit dem Spannungsgenerator, mit den Aufzeichnungseinrichtungen (16) und mit den Spannungsmeßeinrichtungen (18), wobei besagte Steuereinrichtungen (20) den Betrieb des Spannungsgenerators (14), der Aufzeichnungseinrichtungen (16) und der Spannungsmeßeinrichtungen (18) steuert,
**dadurch gekennzeichnet**, daß:
- der Spannungsgenerator (14) geregelt wird und durch einen ersten Eingang verbunden ist mit dem Ausgang des Kapazitätsmessers (10),
- der erste Ausgang des Spannungsgenerators (14) verbunden ist mit einem Eingang des Kapazitätsmessers (10),
- der Spannungsgenerator (14) fähig ist, an einem ersten Eingang während einer auf die zweite folgenden dritten Periode eine zur Spannung V2 addierte Regelspannung liefert, wobei diese Regelspannung proportional ist zur Differenz zwischen der Sollspannung und der Spannung, die dem durch den Kapazitätsmesser während der dritten Periode gemessenen kapazitiven Wert entspricht,
und an einem zweiten Ausgang die Regelspannung allein,
- daß die Sollspannung an einem Ausgang der Aufzeichnungseinrichtungen (16) geliefert wird, der verbunden ist mit einem zweiten Eingang des Spannungsgenerators (14),
- die Spannungsmeßeinrichtungen (18) auch verbunden sind mit dem zweiten Ausgang des Spannungsgenerators (14) und fähig sind, auch die Regelspannung nach Bedarf zu liefern.

6. Vorrichtung nach Anspruch 5, dadurch gekennzeichnet, daß die Aufzeichnungseinrichtungen (16) umfassen:
steuerbare Abtasteinrichtungen (160), angeschlossen am Ausgang des Kapazitätsmessers (10) und fähig, eine Abtastung der Spannung durchzuführen, die einem am Ausgang des Kapazitätsmessers gelieferten kapazitiven Wert entspricht,
einen steuerbaren Analog-Digitalkonverter (162), mit dem Eingang verbunden mit einem Ausgang der Abtasteinrichtungen,
Speichereinrichtungen (26a), mit dem Eingang angeschlossen an einen Ausgang des Analog-Digitalkonverters,
einen Digital-Analogkonverter (164), durch einen Eingang mit einem Ausgang der Speichereinrichtungen (26a) verbunden.

7. Vorrichtung nach Anspruch 6, dadurch gekennzeichnet, daß die Aufzeichnungseinrichtungen (16) Auslösungseinrichtungen (166) umfassen, am Ausgang des Kapazitätsmessers (10) angeschlossen und fähig, eine plötzliche Veränderung des durch den Kapazitätsmesser (10) gemessenen kapazitiven Werts festzustellen und nach dieser Feststellung ein Auslösungssignal zu liefern an einem mit einem Eingang der Steuereinrichtungen (20) verbundenen Ausgang.

8. Vorrichtung nach Anspruch 7, dadurch gekennzeichnet, das die Auslösungseinrichtungen (166) ein Differenzierglied umfassen.

9. Vorrichtung nach Anspruch 5, dadurch gekennzeichnet, daß der Spannungsgenerator (14) umfaßt:
- eine steuerbare Spannungsquelle (140), fähig, nacheinander an einem Ausgang die Spannungen V1 und V2 zu liefern,
- einen Differentialverstärker (146), durch einen ersten Eingang mit dem Ausgang des Kapazitätsmessers (10) verbunden und durch einen zweiten Eingang mit dem Ausgang der Aufzeichnungseinrichtungen (16),
- einen steuerbaren Schalter (144), verbunden mit einem Ausgang des Differentialverstärkers (146) und mit dem zweiten Ausgang des Spannungsverstärkers (14),
- einen Summator (142), der durch einen ersten Eingang mit dem zweiten Ausgang des Spannungsgenerators (14) verbunden ist und durch einen zweiten Eingang mit der Spannungsquelle (140) und der den ersten Ausgang des Spannungsgenerators (14) als Ausgang hat.

## Claims

1. Process for the qualification of a capacitive system comprising:
a) during a first period, applying a first polarization voltage V1 to the capacitive system (12) to be qualified, said voltage V1 placing the capacitive system (12) in an initial state with a given capacitive value C1,
b) during a second period, applying a second polarization voltage V2 to the capacitive system (12) to be qualified, said voltage V2 placing the capacitive system (12) in the depletion state with a given capacitive value C2 and measuring the voltage supplied by a capacitance meter and which corresponds to the capacitive value C2 of the system to be qualified,
c) during a third period, applying to the capacitive system (12) a servocontrol voltage added to the voltage V2 so as to maintain the capacitive system (12) in the depletion state with the capacitive value C2, said servocontrol voltage being proportional to the difference between a reference voltage and the voltage corresponding to the capacitive value measured during the third period,
d) measuring the servocontrol voltage, whose time variation permits the desired qualification of the capacitive system,
characterized in that :
e) said three periods follow one another,
f) in a predetermined time interval during the second period in which the capacitive system is in the depletion state and outside the transient state, recording takes place of the voltage corresponding to the capacitive value C2, said voltage serving as the reference voltage.

2. Process according to claim 1, characterized in that the recording of the reference voltage takes place following a detection of a sudden variation of the capacitive value from C1 to C2.

3. Process according to claim 1, characterized in that the recording of the reference voltage takes place from a predetermined instant as from the start of the second period.

4. Process according to claim 1, characterized in that the recording of the reference voltage consists of a sampling for a given time of the voltage corresponding to the capacitive value and a digital storage of the sampled voltage.

5. Automatic apparatus for the qualification of a capacitive system comprising:
- a capacitance meter (10) able to supply a polarization voltage between the terminals (A, B) connected to the capacitive system (12) and to an input a continuous signal proportional to a capacitive value measured between its terminals,
- a controllable voltage generator (14) able to supply successively on a first output:
during a first period, a voltage V1 with a predetermined value in order to bring the capacitive system (12) into an initial state, during a second period a voltage V2 with a predetermined value in order to bring the capacitive system (12) into the depletion state,
- controllable recording means (16) connected to the output of the capacitance meter (10) and able to record and supply a reference value corresponding to a capacitive value measured during the second period,
- controllable voltage measuring means (18) connected at the input to the output of the capacitance meter (10) and able to supply, as required, a voltage corresponding to a capacitive value measured at least as from the second period,
- control means (20) comprising a clock and connected to the voltage generator, to the recording means (16) and to the voltage measuring means (18), said control means (20) controlling the operation of the voltage generator (18), the recording means (16) and the voltage measuring means (18),
characterized in that:
- the voltage generator (14) is controlled and connected by a first input to the output of the capacitance meter (10),
- the first output of the voltage generator (14) is connected to an input of the capacitance meter (10),
- the voltage generator (14) is able to supply on the first output, during a third period following the second period a control voltage added to the voltage V2, said control voltage being proportional to the difference between the reference voltage and the voltage corresponding to the capacitive value measured by the capacitance meter during the third period and on a second output the control voltage only,
- the reference voltage is supplied on an output of the recording means (16) connected to a second input of the voltage generator (14),
- the voltage measuring means (18) are also connected to the second output of the voltage generator (14) and are able to supply, as required, also the control voltage.

6. Apparatus according to claim 5, characterized in that the recording means (16) comprises:
- controllable sampling means (160) connected at the output of the capacitance meter (10) and able to perform a sampling of the voltage corresponding to a capacitive value supplied at the output of the capacitance meter,
- a controllable analog-digital converter (162) connected at the input to an output of the sampling means,
- storing means (26a) connected at the input to an output of the analog-digital converter,
- a digital-analog converter (164) connected by an input to an output of the storage means (26a).

7. Apparatus according to claim 6, characterized in that the recording means (16) comprise triggering means (166) connected at the output of the capacitance meter (10) and able to detect a sudden variation of the capacitive value measured by the capacitance meter (10) and supply at the end of said detection a triggering signal to an output connected to an input of the control means (20).

8. Apparatus according to claim 7, characterized in that the triggering means (166) comprise a differentiator.

9. Apparatus according to claim 5, characterized in that the voltage generator (14) comprises:
- a controllable voltage source (140) able to successively supply the voltages V1 and V2 to an output,
- a differential amplifier (146) connected by a first input to the output of the capacitance meter (10) and by a second input to the output of the recording means (16),
- a controllable switch (144) connected to an output of the differential amplifier (146) and to the second output of the voltage generator (14),
- an adder (142) connected by a first input to the second output of the voltage generator (14) and by a second input to the voltage source (14) and having as the output the first output of the voltage generator (14).
